# EUROPEAN PATENT APPLICATION

(11) **EP 4 761 497 A1**
(43) Date of publication of application: **17.06.2026**
(21) Application number: 25203075.4
(22) Date of filing: 18.09.2025
(51) Int. Cl.: H10B 43/27, H10B 63/00, H10N 70/20, H10N 70/00

(54) **THREE-DIMENSIONAL VERTICAL NONVOLATILE MEMORY DEVICE INCLUDING MEMORY CELL STRINGS, METHOD OF DRIVING THE SAME, AND ELECTRONIC APPARATUS INCLUDING THE SAME**

(30) Priority: 16.12.2024 KR 20240187469
(71) Applicant: Samsung Electronics Co., Ltd., Suwon-si, Gyeonggi-do 16677 (KR)
(72) Inventor: HYUN, Seungdam, 16678 Suwon-si (KR); KIM, Yumin, 16678 Suwon-si (KR); PARK, Garam, 16678 Suwon-si (KR); LEE, Minhyun, 16678 Suwon-si (KR); CHOI, Seokhoon, 16678 Suwon-si (KR); HEO, Hoseok, 16678 Suwon-si (KR)
(74) Representative: Elkington and Fife LLP

(57) **Abstract**

A three-dimensional vertical non-volatile memory device includes a channel layer extending in a first direction, gate electrodes and spacers alternating in the first direction, each of the gate electrodes and each of the spacers extending in a second direction crossing the first direction, an electrochemical layer extending in the first direction between the channel layer and the gate electrodes and between the channel layer and the spacers, and a blocking layer extending in the first direction between the electrochemical layer and the gate electrodes and between the electrochemical layer and the spacers. The electrochemical layer and the channel layer move ions from the electrochemical layer to the channel layer or vice versa according to a voltage applied to the gate electrodes. The blocking layer includes a charge trap layer that extends in the first direction and is configured to trap charges according to the voltage applied to the gate electrodes.

## Description

### FIELD OF THE INVENTION

The disclosure relates to three-dimensional vertical non-volatile memory devices including memory cell strings, methods of driving the three-dimensional vertical non-volatile memory device, and/or electronic apparatuses including the three-dimensional vertical non-volatile memory device.

### BACKGROUND OF THE INVENTION

A non-volatile memory device, as a semiconductor memory device, includes a plurality of memory cells capable of retaining information even in a power-off state and using the stored information again when power is supplied thereto. Non-volatile memory devices may be used in mobile phones, digital cameras, personal digital assistants (PDAs), portable computer devices, stationary computer devices, and other devices.

An example of a non-volatile memory device is a vertical NAND (VNAND). VNAND is a memory device with increased integration by vertically stacking a large number of memory cells. Various technologies have been proposed to realize high capacity in the same region by increasing the number of VNAND stacks. For example, in order to implement VNAND, various technologies, for example, methods using charge traps, methods using phase change materials, methods using resistance change materials, methods using ferroelectrics, and the like, have been proposed. Furthermore, various materials have been researched to improve the performance of a non-volatile memory device, for example, improvement of data reliability, improvement of a driving speed, reduction of consumption power, increase of a degree of integration, and/or the like.

### SUMMARY OF THE INVENTION

Some example embodiments provide three-dimensional vertical non-volatile memory devices including memory cell strings.

Some example embodiments provide three-dimensional vertical non-volatile memory devices having a relatively low driving voltage and/or an improved memory window.

Furthermore, some example embodiments provide methods of driving a three-dimensional vertical non-volatile memory device and/or electronic apparatuses including a three-dimensional vertical non-volatile memory device.

Additional aspects will be set forth in part in the description which follows and, in part, will be apparent from the description, or may be learned by practice of the presented example embodiments of the disclosure.

According to an example embodiment of the disclosure, a three-dimensional vertical non-volatile memory device includes a channel layer extending in a first direction, a plurality of gate electrodes and a plurality of insulating spacers alternately arranged in the first direction, each of the plurality of gate electrodes and each of the plurality of insulating spacers extending in a second direction crossing the first direction, an electrochemical layer extending in the first direction between the channel layer and the plurality of gate electrodes and between the channel layer and the plurality of insulating spacers, and a blocking layer extending in the first direction between the electrochemical layer and the plurality of gate electrodes and between the electrochemical layer and the plurality of insulating spacers, wherein the electrochemical layer and the channel layer are configured to move ions from the electrochemical layer to the channel layer or from the channel layer to the electrochemical layer according to a voltage applied to each of the plurality of gate electrodes, and the blocking layer includes a charge trap layer that extends in the first direction and is configured to trap charges according to the voltage applied to each of the plurality of gate electrodes.

Embodiments may thus provide an electrochemical ion-exchange memory device with improved electrical properties by inserting charge storage layer.

Proposed embodiments, by applying an electrochemical mechanism to memory operation, may enable fine control of the data storage state. Such a property may exhibit excellent neuromorphic characteristics, especially when the memory device is used as a synaptic element. Embodiments may improve the operating voltage and memory window by inserting a charge trap layer into the blocking oxide of the EC-VNAND device. When the charge trap layer is applied, electrons are trapped from the metal into the trap layer during the program operation. This shifts Vth more in the positive direction than that of a typical ECRAM. Conversely, during the erase operation, holes are trapped into the trap layer, shifting Vth further in the negative direction. As a result, the memory window becomes larger.

In the case of the proposed embodiments, it may be seen that the memory window is significantly improved compared to the prior art. This is because the charges trapped in the charge trap layer provide an additional contribution to the memory window beyond that obtained from the base structure. In the case of prior art, an operating voltage of 12V is required to obtain the maximum memory window of 6.73V. However, in the case of the proposed embodiments, the maximum memory window of 7.47V is confirmed even at an operating voltage of 10V. Through the proposed invention, it may be seen that not only the operating voltage but also the memory window is improved.

The charge trap layer may include at least one material of silicon nitride, aluminum nitride, hafnium nitride, silicon oxynitride, aluminum oxynitride, hafnium oxynitride, hafnium oxide, zirconium oxide, tantalum oxide, or titanium oxide.

The charge trap layer may include a metal oxide material doped with Si or Al.

The blocking layer may further include at least one of a first barrier layer extending in the first direction between the charge trap layer and the plurality of gate electrodes and between the charge trap layer and the plurality of insulating spacers, or a second barrier layer extending in the first direction between the electrochemical layer and the charge trap layer.

The first barrier layer and the second barrier layer may each include at least one material of aluminum oxide, silicon oxide, hafnium oxide, or zirconium oxide.

The thickness in the second direction of the blocking layer may be about 5 nm to about 15 nm, and the thickness in the second direction of the charge trap layer may be about 1 nm to about 10 nm.

The blocking layer may include both of the first barrier layer and the second barrier layer, and the thickness in the second direction of the first barrier layer may be less than the thickness in the second direction of the second barrier layer.

The electrochemical layer may include an oxide of at least one metal of scandium (Sc), yttrium (Y), lanthanum (La), titanium (Ti), zirconium (Zr), hafnium (Hf), rutherfordium (Rf), cerium (Ce), vanadium (V), niobium (Nb), tantalum (Ta), chromium (Cr), molybdenum (Mo), or tungsten (W).

When the electrochemical layer includes an oxide of at least one metal of Sc, Y, or La, a ratio of oxygen atoms to metal atoms in the electrochemical layer may be about 1.35 or less; when the electrochemical layer includes an oxide of at least one metal of Ti, Zr, Hf, Rf, or Ce, a ratio of oxygen atoms to metal atoms in the electrochemical layer may be about 1.8 or less; when the electrochemical layer may include an oxide of at least one metal of V, Nb, or Ta, a ratio of oxygen atoms to metal atoms in the electrochemical layer may be about 2.25 or less; and when the electrochemical layer may include an oxide of at least one metal of Cr, Mo, or W, a ratio of oxygen atoms to metal atoms in the electrochemical layer may be about 2.7 or less.

The electrochemical layer may include an ion reservoir layer extending in the first direction adjacent to the blocking layer and an electrolyte layer extending in the first direction adjacent to the channel layer.

The ion reservoir layer and the electrolyte layer may each include an oxide of at least one metal of Sc, Y, La, Ti, Zr, Hf, Rf, Ce, V, Nb, Ta, Cr, Mo, or W, and a ratio of oxygen to an entire material in the ion reservoir layer may be less than a ratio of oxygen to an entire material in the electrolyte layer.

The thickness of the electrolyte layer in the second direction may be less than the thickness of the ion reservoir layer in the second direction.

The electrochemical layer may have a composition in which a ratio of oxygen gradually or continuously increases toward the channel layer in the second direction within the electrochemical layer.

The channel layer may include at least one oxide semiconductor material of indium-gallium-zinc oxide (IGZO), indium-zinc oxide (IZO), gallium-zinc oxide (GZO), zinc-tin oxide (ZTO), or indium-tungsten oxide (IWO).

According to an example embodiment of the disclosure, a method of driving a three-dimensional vertical non-volatile memory device, the three-dimensional vertical non-volatile memory device including a channel layer extending in a first direction, a plurality of gate electrodes and a plurality of insulating spacers alternately arranged in the first direction, each of the plurality of gate electrodes and each of the plurality of insulating spacers extending in a second direction crossing the first direction, an electrochemical layer extending in the first direction between the channel layer and the plurality of gate electrodes and between the channel layer and the plurality of insulating spacers, and a blocking layer extending in the first direction between the electrochemical layer and the plurality of gate electrodes and between the electrochemical layer and the plurality of insulating spacers, and the blocking layer including a charge trap layer that may be configured to trap charges according to a voltage applied to each of the plurality of gate electrodes includes applying a negative (-) program voltage to one a first gate electrode of the plurality of gate electrodes, moving and trapping electrons in a partial area of the charge trap layer adjacent in the second direction to the first gate electrode one of the plurality of gate electrodes to which the program voltage is applied, and moving ions in a partial area of the channel layer adjacent in the second direction to one of the plurality of gate electrodes to which the program voltage is applied the first gate electrode to a partial area of the electrochemical layer adjacent in the second direction to the one of the plurality of gate electrodes to which the program voltage is applied the first gate electrode so that the partial area of the channel layer has a first resistance.

The method may further include applying a positive (+) erase voltage to one a second gate electrode of the plurality of gate electrodes, moving electrons from a partial area of the charge trap layer adjacent in the second direction to one of the plurality of gate electrodes to which the erase voltage is applied the second gate electrode to the one of the plurality of gate electrodes to which the erase voltage is applied the second gate electrode, and moving ions in a partial area of the electrochemical layer adjacent in the second direction to a gate electrode to which the erase voltage is applied the second gate electrode to a partial area of the channel layer adjacent in the second direction to the one of the plurality of gate electrodes to which the erase voltage is applied the second gate electrode so that the partial area of the channel layer has a lower second resistance than the first resistance.

The method may further included maintaining a third gate electrode of the plurality of gate electrodes to which the program voltage or the erase voltage is not applied in a floating state so that ions do not move between an area of the electrochemical layer and an area of the channel layer adjacent in the second direction to the some of the plurality of gate electrodes in the floating state the third gate electrode.

The method may further include applying a positive (+) read voltage to only a gate electrode of a selected memory cell from which data may be to be read out among the plurality of gate electrodes and applying a positive (+) pass voltage to other gate electrodes, wherein the read voltage may be higher than the program voltage and lower than the erase voltage, and the pass voltage may be higher than the read voltage and lower than the erase voltage.

When a partial area of the channel layer adjacent in the second direction to a gate electrode to which the read voltage is applied has a first resistance, a first current may flow through the channel layer, and when the partial area of the channel layer adjacent in the second direction to the gate electrode to which the read voltage is applied has a second resistance, a second current greater than the first current may flow through the channel layer.

According to an example embodiment of the disclosure, an electronic apparatus includes a processing circuit, and a three-dimensional vertical non-volatile memory device, wherein the three-dimensional vertical non-volatile memory device may include a channel layer extending in a first direction, a plurality of gate electrodes and a plurality of insulating spacers alternately arranged in the first direction, each of the plurality of gate electrodes and each of the plurality of insulating spacers extending in a second direction crossing the first direction, an electrochemical layer extending in the first direction between the channel layer and the plurality of gate electrodes and between the channel layer and the plurality of insulating spacers, and a blocking layer extending in the first direction between the electrochemical layer and the plurality of gate electrodes and between the electrochemical layer and the plurality of insulating spacers, wherein the electrochemical layer and the channel layer are configured to move ions from the electrochemical layer to the channel layer or from the channel layer to the electrochemical layer according to a voltage applied to each of the plurality of gate electrodes, and the blocking layer may include a charge trap layer that extends in the first direction and may be configured to trap charges according to the voltage applied to the each of plurality of gate electrodes.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a block diagram of a memory system according to an example embodiment;
FIG. 2 is a block diagram showing an implementation example of a memory device illustrated in FIG. 1;
FIG. 3 is a schematic block diagram of a memory cell array illustrated in FIG. 1;
FIG. 4 is an equivalent circuit corresponding to a memory block according to an example embodiment;
FIG. 5 is a vertical cross-sectional view schematically showing a structure of a memory cell string according to an example embodiment;
FIG. 6 is a horizontal cross-sectional view schematically showing a structure of a memory cell string according to an example embodiment;
FIG. 7 is a vertical cross-sectional view schematically showing a structure of a memory cell string according to another example embodiment;
FIGS. 8A to 8G are views showing an example of a method of manufacturing the memory cell string illustrated in FIG. 7;
FIG. 9 is a view showing an example of a program operation of a memory cell string according to an example embodiment;
FIG. 10 is a view showing an example of an erase operation of a memory cell string according to an example embodiment;
FIG. 11 is a view showing an example of a read operation on a selected memory cell of a memory cell string according to an example embodiment after the program operation;
FIG. 12 is a view showing an example of a read operation on a selected memory cell of a memory cell string according to an example embodiment after the erase operation;
FIG. 13 is a graph showing the principle of a memory window increase by a charge trap layer;
FIGS. 14 and 15 are graphs showing examples of voltage-current characteristics of one memory cell of a memory cell string according to a comparative example;
FIGS. 16 and 17 are graphs showing examples of voltage-current properties of one memory cell of a memory cell string according to an example embodiment;
FIGS. 18 and 19 are graphs showing examples of voltage-current properties of one memory cell of a memory cell string according to another example embodiment;
FIG. 20 is a vertical cross-sectional view schematically showing a structure of a memory cell string according to another example embodiment;
FIG. 21 is a vertical cross-sectional view schematically showing a structure of a memory cell string according to another example embodiment;
FIG. 22 is a vertical cross-sectional view schematically showing a structure of a memory cell string according to another example embodiment;
FIG. 23 is a conceptual view schematically showing a device architecture applicable to an example electronic apparatus including a memory device according to an example embodiment; and
FIG. 24 is a block diagram schematically showing a neuromorphic apparatus including a memory device according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a three-dimensional vertical non-volatile memory device including a memory cell string will be described in detail with reference to the accompanying drawings. Throughout the drawings, like reference numerals denote like elements, and sizes of components in the drawings may be exaggerated for convenience of explanation and clarity. Furthermore, as the example embodiments described below are examples, other modifications may be produced from the example embodiments.

When a constituent element is disposed "above" or "on" to another constituent element, the constituent element may be only directly on the other constituent element or above the other constituent elements in a non-contact manner. As used herein, the singular forms "a," "an," and "the" are intended to include the plural forms as well, unless the context clearly indicates otherwise. Furthermore, it will be further understood that the terms "comprises" and/or "comprising" used herein specify the presence of stated features or components, but do not preclude the presence or addition of one or more other features or components.

The use of the terms "a," "an," "the," and similar referents in the context of describing the disclosure are to be construed to cover both the singular and the plural. Also, the operations of all methods described herein can be performed in any suitable order unless otherwise indicated herein or otherwise clearly contradicted by context. The disclosure is not limited to the described order of the steps.

Furthermore, terms such as "...portion," "...unit," "...module," and "...block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes

The use of any and all examples, or language (e.g., "such as") provided herein, is intended merely to better illuminate the disclosure and does not pose a limitation on the scope of the disclosure unless otherwise claimed.

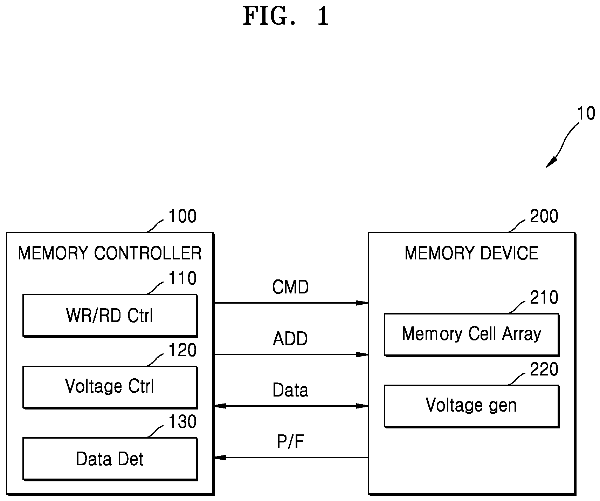

FIG. 1 is a block diagram of a memory system 10 according to an example embodiment. Referring to FIG. 1, the memory system 10 according to an example embodiment may include a memory controller 100 and a memory device 200. The memory controller 100 may perform a control operation on the memory device 200. In an example, the memory controller 100 may perform a program (or write), read, or erase operation on the memory device 200 by providing an address ADD and a command CMD to the memory device 200. Furthermore, data for a program operation and data that is readout may be transceived between the memory controller 100 and the memory device 200. The memory device 200 may provide a pass/fail signal to the memory controller 100 according to a result of reading out the data, and the memory controller 100 may control a write/read operation on a memory cell array 210 in response to the pass/fail signal.

The memory device 200 may include the memory cell array 210 and a voltage generator 220. The memory cell array 210 may include a plurality of memory cells arranged in regions where a plurality of word lines and a plurality of bit lines cross each other. The memory cell array 210 may include non-volatile memory cells that non-volatilely store data, and as non-volatile memory cells, the memory cell array 210 may include flash memory cells, such as a NAND flash memory cell array, a NOR flash memory cell array, or the like. In the following description, some example embodiments of the disclosure are described assuming that the memory cell array 210 includes a flash memory cell array, and thus, the memory device 200 is a non-volatile memory device.

The memory controller 100 may include a write/read controller 110, a voltage controller 120, and a data determination unit 130.

The write/read controller 110 may generate the address ADD and the command CMD to perform program/read and erase operations on the memory cell array 210. Furthermore, the voltage controller 120 may generate a voltage control signal to control at least one voltage level used in the memory device 200 that is non-volatile. For example, the voltage controller 120 may generate a voltage control signal to control a voltage level of a word line to read out data from the memory cell array 210 or to program data to the memory cell array 210.

The data determination unit 130 may perform a determination operation on the data read out from the memory device 200. For example, by determining the data read out from the memory cells, the data determination unit 130 may determine the number of on-cells and/or off-cells among the memory cells. Further, when a program is performed on a plurality of memory cells, by determining a state of data of the memory cells using a certain read voltage, whether the program is normally completed for all cells may be determined.

As described above, the memory cell array 210 may include non-volatile memory cells, for example, flash memory cells. Furthermore, the flash memory cells may be implemented in various forms. For example, the memory cell array 210 may include three-dimensional (or vertical) NAND (VNAND) memory cells.

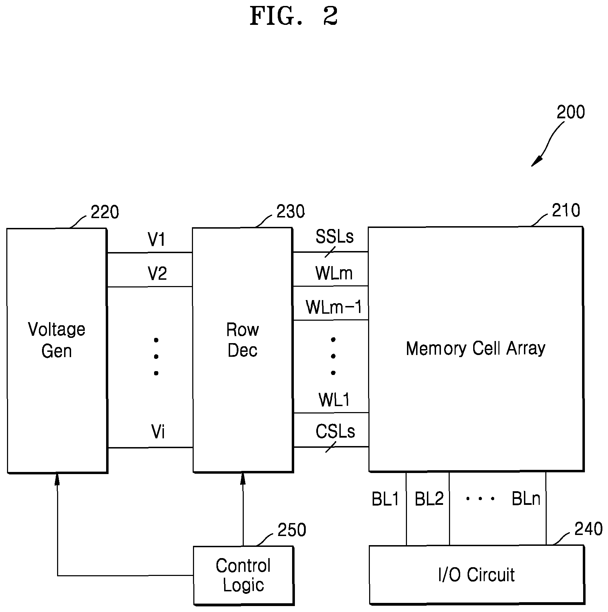

FIG. 2 is a block diagram showing an implementation example of the memory device 200 illustrated in FIG. 1. Referring to FIG. 2, the memory device 200 may include a row decoder 230, an input/output circuit 240, and a control logic 250.

The memory cell array 210 may be connected to one or more string select lines SSLs, a plurality of word lines WL1 to WLm, and one or more common source lines CSLs, and furthermore, to a plurality of bit lines BL1 to BLn. The voltage generator 220 may generate one or more word line voltages V1 to Vi, and the word line voltages V1 to Vi may be provided to the row decoder 230. Signals for program/read/erase operations may be applied to the memory cell array 210 through the bit lines BL1 to BLn.

Furthermore, data to be programmed may be provided to the memory cell array 210 through the input/output circuit 240, and data that is read out may be provided to the outside (e.g., the memory controller 100) through the input/output circuit 240. The control logic 250 may provide various control signals related to memory operations to the row decoder 230 and the voltage generator 220.

The word line voltages V1 to Vi may be provided through various lines (SSLs, WL1 to WLm, CSLs) according to a decoding operation of the row decoder 230. For example, the word line voltages V1 to Vi may include a string select voltage, a word line voltage, and a ground select voltage, and the string select voltage may be provided to the string select lines SSLs, the word line voltage may be provided to the word lines WL1 to WLm, and the ground select voltage may be provided to the common source lines CSLs.

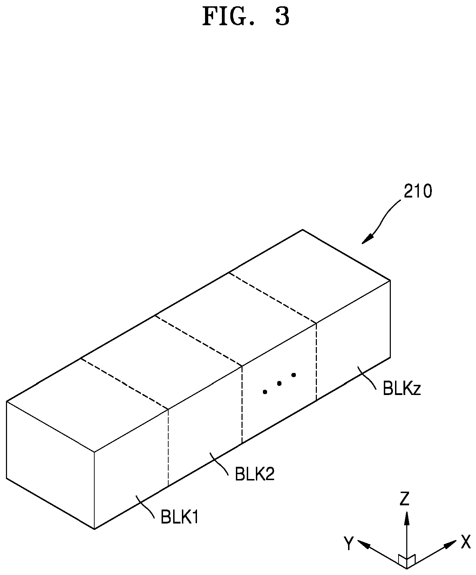

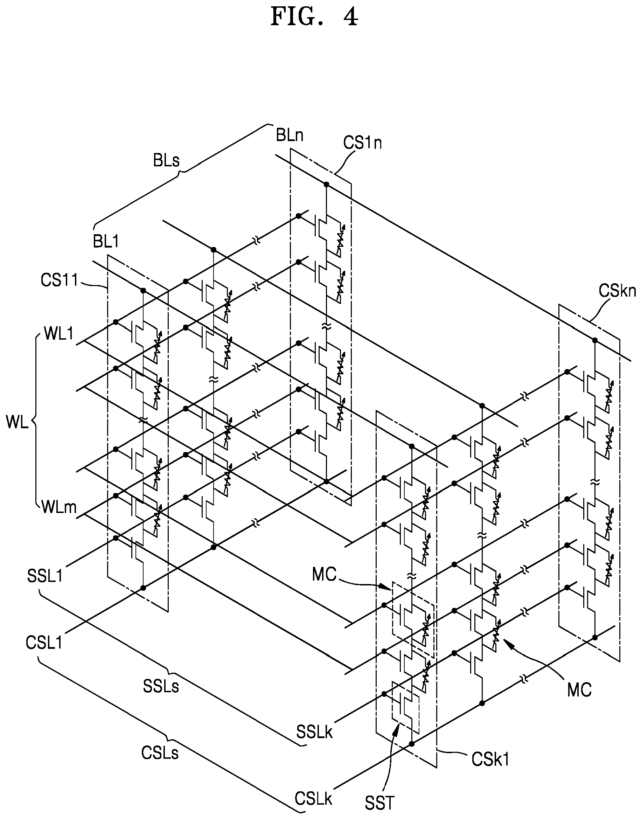

FIG. 3 is a schematic block diagram of the memory cell array 210 illustrated in FIG. 1. Referring to FIG. 3, the memory cell array 210 may include a plurality of memory blocks BLK1 to BLKz. Each memory block BLK may have a three-dimensional structure (or a vertical structure). For example, each memory block BLK may include a structure extending in first to third directions. For example, each memory block BLK may include a plurality of memory cell strings extending in the first direction (Z direction). Accordingly, the plurality of memory cell strings may have a three-dimensional vertical structure. In this point, the memory device 200 may be a three-dimensional vertical non-volatile memory device. Each memory cell string is connected to the bit line BL, the string select line SSL, the word lines WLs, and the common source line CSL. Accordingly, the memory blocks BLK1 to BLKz each may be connected to the bit lines BLs, the string select lines SSLs, the word lines WLs, and the common source lines CSLs. The memory blocks BLK1 to BLKz configured as above are described in detail with reference to FIG. 4.

FIG. 4 is an equivalent circuit corresponding to a memory block according to an example embodiment. For example, FIG. 4 illustrates one of the memory blocks BLK1 to BLKz of the memory cell array 210 of FIG. 3. Referring to FIGS. 3 and 4, the memory blocks BLK1 to BLKz may each include a plurality of memory cell strings CS11 to CSkn. The memory cell strings CS11 to CSkn may be arranged two-dimensionally in a row direction and a column direction to thus form rows and columns. Each of the memory cell strings CS11 to CSkn may include a plurality of memory cells MCs and a plurality of string select transistors SSTs. The memory cells MCs and the string select transistors SSTs of each of the memory cell strings CS11 to CSkn may be stacked in a height direction.

Rows of the memory cell strings CS11 to CSkn are connected to different string select lines SSL1 to SSLk, respectively. For example, the string select transistors SSTs of the memory cell strings CS11 to CS1n are connected in common to the string select line SSL1. The string select transistors SSTs of the memory cell strings CSk1 to CSkn are connected in common to the string select line SSLk.

Furthermore, the columns of the memory cell strings CS11 to CSkn are connected to different bit lines BL1 to BLn, respectively. For example, the memory cells MCs and the string select transistors SSTs of the memory cell strings CS11 to CSk1 may be connected in common to the bit line BL1, and the memory cells MCs and the string select transistors SSTs of the memory cell strings CS1n to CSkn may be connected in common to the bit line BLn.

Furthermore, rows of the memory cell strings CS11 to CSkn may be connected to different common source lines CSL1 to CSLk, respectively. For example, the string select transistors SSTs of the memory cell strings CS11 to CS1n may be connected in common to the common source line CSL1, and the string select transistors SSTs of the memory cell strings CSk1 to CSkn may be connected in common to the common source line CSLk.

The memory cells MCs at the same height from a substrate (or the string select transistors SSTs) may be connected in common to one word line WL, and the memory cells MCs at different heights may be connected to different word lines WL1 to WLm, respectively.

The memory block illustrated in FIG. 4 is an example. The technical concepts of the disclosure are not limited to the memory block illustrated in FIG. 4. For example, the number of rows of the memory cell strings CS11 to CSkn may be increased or decreased. As the number of rows of the memory cell strings CS11 to CSkn is changed, the number of string select lines SSL1 to SSLk connected to the rows of the memory cell strings CS11 to CSkn, and the number of memory cell strings CS11 to CSkn connected to one bit line, may also be changed. As the number of rows of the memory cell strings CS11 to CSkn is changed, the number of common source lines CSL1 to CSLk connected to the rows of the memory cell strings CS11 to CSkn may also be changed. Furthermore, the number of columns of the memory cell strings CS11 to CSkn may be increased or decreased. As the number of columns of the memory cell strings CS11 to CSkn is changed, the number of bit lines BL1 to BLn connected to the columns of the memory cell strings CS11 to CSkn, and the number of memory cell strings CS11 to CSkn connected to one string select line SSL, may also be changed.

The height of each of the memory cell strings CS11 to CSkn may be increased or decreased. For example, the number of memory cells MCs stacked on each of the memory cell strings CS11 to CSkn may be increased or decreased. As the number of memory cells MCs stacked on each of the memory cell strings CS11 to CSkn is changed, the number of word lines WLs may also be changed. For example, the number of string select transistors SSTs provided to each of the memory cell strings CS11 to CSkn may be increased. As the number of string select transistors SSTs provided to each of the memory cell strings CS11 to CSkn is changed, the number of string select lines SSL or common source lines CSLs may also be changed. As the number of string select transistors SSTs increases, the string select transistors SSTs may be stacked in the same form as the memory cells MCs.

For example, the write and read operations may be performed for each row of the memory cell strings CS11 to CSkn. The memory cell strings CS11 to CSkn may be selected for each row by the common source lines CSLs, and the memory cell strings CS11 to CSkn may be selected for each row by the string select lines SSLs. In a selected row of the memory cell strings CS11 to CSkn, the write and read operations may be performed for each page. For example, a page may be one row of the memory cells MCs connected to one word line WL. The memory cells MCs may be selected for each page by the word lines WL in the selected row of the memory cell strings CS11 to CSkn.

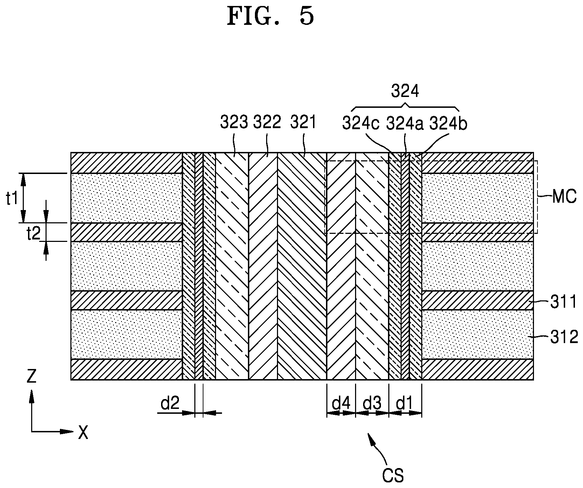

The memory cells MCs in each of the memory cell strings CS11 to CSkn may correspond to a circuit in which a transistor and a resistor are connected in parallel. For example, FIG. 5 is a schematic vertical cross-sectional view of a structure of each memory cell string CS according to an example embodiment. Referring to FIG. 5, the memory cell string CS may include a plurality of insulating spacers 311 and a plurality of gate electrodes 312, which are alternatively stacked in a vertical direction, that is, in the first direction (Z direction) perpendicularly crossing the second direction (X direction). The insulating spacers 311 and the gate electrodes 312 may extend in a horizontal direction, that is, the second direction. Each gate electrode 312 may be connected to the word line WL, or each gate electrode 312 may be the word line WL, as it is.

The insulating spacers 311 may include one of various insulating dielectric materials, for example, a silicon oxide, an aluminum oxide, a silicon nitride, and the like, but the disclosure is not limited thereto. The gate electrode 312 may include a conductive material including at least one of tungsten (W), molybdenum (Mo), ruthenium (Ru), polysilicon, or TiN, a two-dimensional metallic material, or a combination thereof. The two-dimensional metallic material may include at least one of graphene, TaS₂, TaSe₂, NbS₂, NbSe₂, PdTe₂, PtTe₂, NbTe₂, TiSe₂, VSe₂, AuSe, or MoTe₂.

Furthermore, the memory cell string CS may include a channel hole that penetrates a plurality of insulating spacers 311 and a plurality of gate electrodes 312 in the first direction. A plurality of layers for forming a channel and resistance may be provided in the channel hole. For example, the memory cell string CS may include an insulating support 321 provided at the center of the channel hole to extend in the first direction, a channel layer 322 surrounding the insulating support 321 and extending in the first direction, an electrochemical layer 323 surrounding the channel layer 322 and extending in the first direction, and a blocking layer 324 surrounding the electrochemical layer 323 and extending in the first direction. The electrochemical layer 323 may be provided between the channel layer 322 and the gate electrodes 312 and between the channel layer 322 and the insulating spacers 311. The blocking layer 324 may be provided between the electrochemical layer 323 and the gate electrodes 312 and between the electrochemical layer 323 and the insulating spacers 311.

The blocking layer 324 may have a multilayer structure including a charge trap layer 324a. For example, the blocking layer 324 may include a first barrier layer 324b extending in the first direction, the charge trap layer 324a extending in the first direction, and a second barrier layer 324c extending in the first direction. The opposite side surfaces of the charge trap layer 324a may be surrounded by the first barrier layer 324b and the second barrier layer 324c, respectively. The first barrier layer 324b may be provided between the charge trap layer 324a and the gate electrodes 312 and between the charge trap layer 324a and the insulating spacers 311, and the second barrier layer 324c may be provided between the electrochemical layer 323 and the charge trap layer 324a.

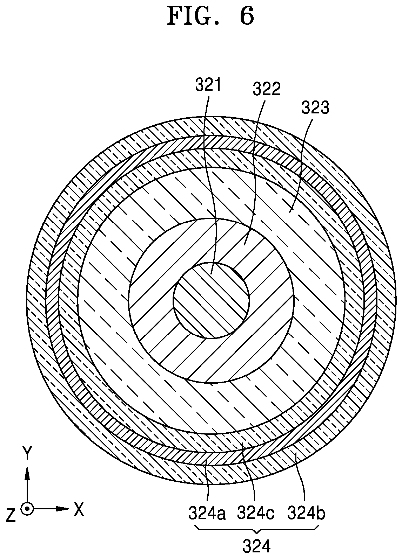

FIG. 6 is a horizontal cross-sectional view schematically showing a structure of the memory cell string CS according to an example embodiment. Referring to FIG. 6, the insulating support 321, the channel layer 322, the electrochemical layer 323, the second barrier layer 324c, the charge trap layer 324a, and the first barrier layer 324b may be sequentially provided from the center in the form of concentric circles. Accordingly, the first barrier layer 324b may have a cylindrical shape surrounding the charge trap layer 324a. The charge trap layer 324a may have a cylindrical shape surrounding the second barrier layer 324c. The second barrier layer 324c may have a cylindrical shape surrounding the electrochemical layer 323. The electrochemical layer 323 may have a cylindrical shape surrounding the channel layer 322. The channel layer 322 may have a cylindrical shape surrounding the insulating support 321. Although not illustrated in FIG. 6, the insulating spacers 311 and the gate electrodes 312 may be alternately stacked in the first direction while surrounding the blocking layer 324.

To this end, the blocking layer 324 may be conformally deposited on the insulating spacers 311 and the gate electrodes 312 and may extend in the first direction. The electrochemical layer 323 may be conformally deposited along the surface of the blocking layer 324 and may extend in the vertical direction. The channel layer 322 may be conformally deposited along the surface of the electrochemical layer 323 and may extend in the vertical direction. The insulating support 321 may be provided to fill the remaining space at the center of the channel hole and may extend in the vertical direction.

Thus, the channel layer 322 may have a shape extending in the first direction facing the insulating spacers 311 and the gate electrodes 312, the electrochemical layer 323 may have a shape extending in the first direction between the channel layer 322 and the gate electrodes 312, and the blocking layer 324 may have a shape extending in the first direction between the electrochemical layer 323 and the gate electrodes 312.

Although it is not illustrated, a drain may be provided on the top surface of the memory cell string CS to cover at least the upper surface of the channel layer 322. The drain may include a doped semiconductor material. The drain may be electrically connected to the upper portion of the channel layer 322. Furthermore, the bit line BL may be connected to the drain. A source may be provided on the lower surface of the channel layer 322. The source may include a doped semiconductor material. The source may be electrically connected to the lower portion of the channel layer 322. Furthermore, the common source line CSL may be connected to the source.

The electrochemical layer 323 may be an ion reservoir layer that includes a plurality of donor ions and is capable of accepting or discharging the plurality of donor ions. According to an example embodiment, ion exchange may occur between the channel layer 322 and the electrochemical layer 323 according to a program voltage (e.g., a write voltage) or erase voltage applied to the gate electrodes 312. For example, when a negative (-) write voltage is applied to the gate electrodes 312, as ions are moved from the channel layer 322 to the electrochemical layer 323, the ion concentration in the channel layer 322 may be decreased. In this case, the resistance of the channel layer 322 may be increased. Reversely, when a positive (+) erase voltage is applied to the gate electrodes 312, as ions are moved from the electrochemical layer 323 to the channel layer 322, the ion concentration in the channel layer 322 may be increased. In this case, the resistance of the channel layer 322 may be decreased. Accordingly, the channel layer 322 may have a current passage function and a resistance change layer function together.

In an example embodiment, ions may be donor ions that serve as a donor to provide electrons. For example, donor ions may be oxygen vacancies. The electrochemical layer 323 may include a metal oxide material that includes a relatively large amount of donor ions, such as oxygen vacancies, or is easy to accept/discharge donor ions. For example, the electrochemical layer 323 may include oxide of at least one metal of a Group 3 metal, such as scandium (Sc), yttrium (Y), lanthanum (La), or cerium (Ce), a Group 4 metal, such as titanium (Ti), zirconium (Zr), hafnium (Hf), or rutherfordium (Rf), a Group 5 metal, such as vanadium (V), niobium (Nb), or tantalum (Ta), or a Group 6 metal, such as chromium (Cr), molybdenum (Mo), or tungsten (W). Although cerium (Ce) belongs to the Group 3 metal, cerium (Ce) may be treated like the Group 4 metal because cerium (Ce) may exhibit a tetravalent oxidation state.

In order for the electrochemical layer 323 to include donor ions (e.g., oxygen vacancies) at a relatively high concentration, the electrochemical layer 323 may have a stoichiometrically oxygen-deficient composition. For example, when the electrochemical layer 323 includes an oxide of a Group 3 metal, a ratio of oxygen atoms to metal atoms in the electrochemical layer 323 may be about 1.35 or less. When the electrochemical layer 323 includes an oxide of a Group 4 metal, a ratio of oxygen atoms to metal atoms in the electrochemical layer 323 may be about 1.8 or less. When the electrochemical layer 323 includes an oxide of a Group 5 metal, a ratio of oxygen atoms to metal atoms in the electrochemical layer 323 may be about 2.25 or less. When the electrochemical layer 323 includes an oxide of a Group 6 metal, a ratio of oxygen atoms to metal atoms in the electrochemical layer 323 may be about 2.7 or less.

The channel layer 322 may include a material that is easy to accept/discharge ions (e.g., oxygen vacancies) and has electrical resistance that varies depending on the concentration of ions. To this end, the channel layer 322 may include an oxide semiconductor material. For example, the channel layer 322 may include at least one oxide semiconductor material among indium-gallium-zinc oxide (IGZO), indium-zinc oxide (IZO), gallium-zinc oxide (GZO), zinc-tin oxide (ZTO), or indium-tungsten oxide (IWO). Furthermore, the channel layer 322 may include various other oxide semiconductor materials in addition to IGZO, IZO, GZO, ZTO, or IWO.

According to an example embodiment, charges may be trapped in the charge trap layer 324a of the blocking layer 324 according to a program voltage (i.e., a write voltage) or erase voltage applied to the gate electrodes 312. For example, when a negative (-) write voltage is applied to the gate electrodes 312, electrons are moved from the gate electrodes 312 to the charge trap layer 324a so that the electrons may be trapped in the charge trap layer 324a. The electrons trapped in the charge trap layer 324a may perform an operation to increase a threshold voltage. Reversely, when a positive (+) erase voltage is applied to the gate electrodes 312, the electrons trapped in the charge trap layer 324a may be moved to the gate electrodes 312. In this case, holes may be present in the charge trap layer 324a, and thus the threshold voltage may be lowered.

The charge trap layer 324a may include a metal nitride material or a metal oxide material that may trap or provide charges according to the voltage applied to the gate electrodes 312. For example, the charge trap layer 324a may include at least one of a metal nitride material, such as silicon nitride (SiN), aluminum nitride (AIN), hafnium nitride (HfN), silicon oxynitride (SiON), aluminum oxynitride (AlON), or hafnium oxynitride (HfON), or a metal oxide material, such as hafnium oxide (HfO), zirconium oxide (ZrO), tantalum oxide (TaO), or titanium oxide (TiO). When the charge trap layer 324a includes a metal oxide material, such as hafnium oxide, zirconium oxide, tantalum oxide, or titanium oxide, in order for the charge trap layer 324a to have a sufficient charge trap site, the metal oxide material may be doped with silicon (Si) or aluminum (Al).

The first barrier layer 324b may function to prevent or reduce the leakage of the charges trapped in the charge trap layer 324a to the gate electrodes 312. The second barrier layer 324c may function to prevent or reduce ion exchange between the charge trap layer 324a and the electrochemical layer 323, and may function to prevent or reduce the leakage of the charges trapped in the charge trap layer 324a to the electrochemical layer 323. The first barrier layer 324b and the second barrier layer 324c may include, for example, at least one metal oxide material of aluminum oxide (AlO), silicon oxide (SiO), hafnium oxide, or zirconium oxide. The metal oxide materials for the first barrier layer 324b and the second barrier layer 324c may not be doped and may have a composition that is not stoichiometrically deficient in oxygen.

Referring back to FIG. 5, as indicated by the dashed box, any one of the gate electrodes 312, and a portion of the blocking layer 324, a portion of the electrochemical layer 323, and a portion of the channel layer 322, which are adjacent to one another in the horizontal direction, that is, the second direction, with respect to the one of the gate electrodes 312, may form one memory cell MC. For example, one gate electrode 312, the portion of the blocking layer 324, the portion of the electrochemical layer 323, and the portion of the channel layer 322, which are adjacent to the gate electrode 312 in the horizontal direction, may form a transistor. The portion of the channel layer 322 may also form a resistor. In this point, the channel layer 322 may perform both functions of a channel of a transistor and a resistance change layer. Accordingly, each of the memory cells MCs may correspond to a circuit in which a transistor and a resistor are connected in parallel. Such memory cells MCs are arranged in a vertical stack structure to thus form each memory cell string CS. According to an example embodiment, as an oxide semiconductor material having relatively high electrical conductivity compared with polysilicon (p-Si) is used as the channel layer 322, the number of memory cells MCs stackable in the memory cell string CS may be increased.

The thickness of one memory cell MC may be determined by a height t1 in the first direction of one of the gate electrodes 312, and an interval between the two memory cells MCs adjacent in the first direction may be determined by a height t2 in the first direction of one of the insulating spacers 311. The degree of integration of the memory cell MC may be increased by reducing the height t2 in the first direction of one insulating spacer 311 or the interval between the two adjacent gate electrodes 312 in the first direction. For example, the height t1 in the first direction of one of the gate electrodes 312 may be about 20 nm or less. According to an example embodiment, as a driving voltage applied to each of the gate electrodes 312 is relatively low, the height t2 in the first direction of one insulating spacer 311 may be decreased. For example, the height t2 in the first direction of one insulating spacer 311 may be about 15 nm or less, about 10 nm or less, or about 8 nm or less.

A thickness d1 in the second direction of the blocking layer 324 may be, for example, about 5 nm to about 15 nm. A thickness d2 in the second direction of the charge trap layer 324a may be about 10% to about 60% of the thickness d1 in the second direction of the blocking layer 324. For example, the thickness d2 in the second direction of the charge trap layer 324a may be about 1 nm to about 10 nm. The first barrier layer 324b and the second barrier layer 324c may have the same thickness in the second direction, but the disclosure is not limited thereto. When the leakage of charges from the charge trap layer 324a to the gate electrodes 312 is sufficiently small, the thickness in the second direction of the first barrier layer 324b between the charge trap layer 324a and the gate electrodes 312 may be less than the thickness in the second direction of the second barrier layer 324c between the charge trap layer 324a and the electrochemical layer 323. Furthermore, a thickness d3 in the second direction of the electrochemical layer 323 may be, for example, about 2 nm to about 20 nm. A thickness d4 in the second direction of the channel layer 322 may be, for example, about 2 nm to about 10 nm.

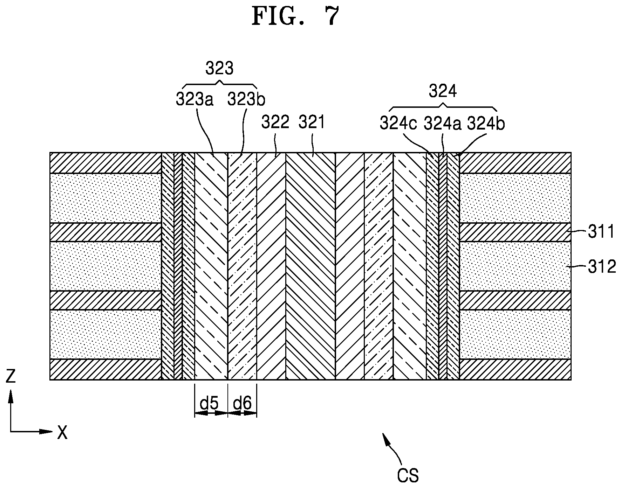

FIG. 7 is a vertical cross-sectional view schematically showing the structure of the memory cell string CS according to another example embodiment. Referring to FIG. 7, the electrochemical layer 323 may have a multilayer structure. For example, the electrochemical layer 323 may include an ion reservoir layer 323a extending in the first direction and an electrolyte layer 323b extending in the first direction. The ion reservoir layer 323a may be arranged adjacent to the blocking layer 324, and the electrolyte layer 323b may be arranged adjacent to the channel layer 322. In other words, the electrolyte layer 323b may be provided between the ion reservoir layer 323a and the channel layer 322. The electrolyte layer 323b may function as an ion move path between the channel layer 322 and the ion reservoir layer 323a when a write voltage or an erase voltage is applied to the gate electrodes 312, and as a barrier layer that prevents or reduces the ion exchange between the channel layer 322 and the ion reservoir layer 323a when a write voltage or an erase voltage is not applied to the gate electrodes 312.

The ion reservoir layer 323a and the electrolyte layer 323b may each include, for example, an oxide of at least one metal of a Group 3 metal, such as Sc, Y, or La, a Group 4 metal, such as Ti, Zr, Hf, Rf, or Ce, a Group 5 metal, such as V, Nb, or Ta, or a Group 6 metal, such as Cr, Mo, or W. In order for the ion reservoir layer 323a to include donor ions (e.g., oxygen vacancies) at a relatively high concentration, a ratio of oxygen to the entire material in the ion reservoir layer 323a may be less than a ratio of oxygen to the entire material in the electrolyte layer 323b. For example, while the ion reservoir layer 323a may have a stoichiometrically oxygen-deficient composition, the electrolyte layer 323b may have a composition that is not stoichiometrically deficient in oxygen. In other words, the concentration of donor ions in the ion reservoir layer 323a may be greater than the concentration of donor ions in the electrolyte layer 323b. In the following description, donor ions are briefly referred to as ions.

A thickness d5 in the second direction of the ion reservoir layer 323a may be, for example, about 2 nm to about 10 nm. A thickness d6 in the second direction of the electrolyte layer 323b may be, for example, about 1 nm to about 10 nm. To facilitate the ion movement between the ion reservoir layer 323a and the channel layer 322, the thickness d6 in the second direction of the electrolyte layer 323b may be less than the thickness d5 in the second direction of the ion reservoir layer 323a. For example, the thickness d6 in the second direction of the electrolyte layer 323b may be about 1 nm to about 5 nm. As the electrolyte layer 323b that prevents or reduces the ion exchange between the channel layer 322 and the ion reservoir layer 323a is provided between the channel layer 322 and the ion reservoir layer 323a, the ion reservoir layer 323a may include ions at a much higher concentration. For example, the ion reservoir layer 323a may include ions at a higher concentration than that of the electrochemical layer 323 of the single layer structure illustrated in FIG. 5.

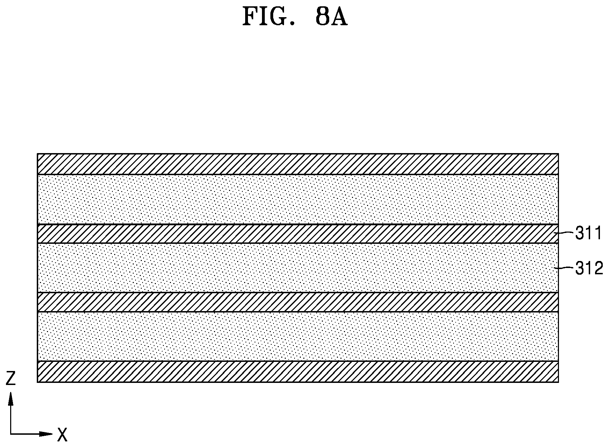

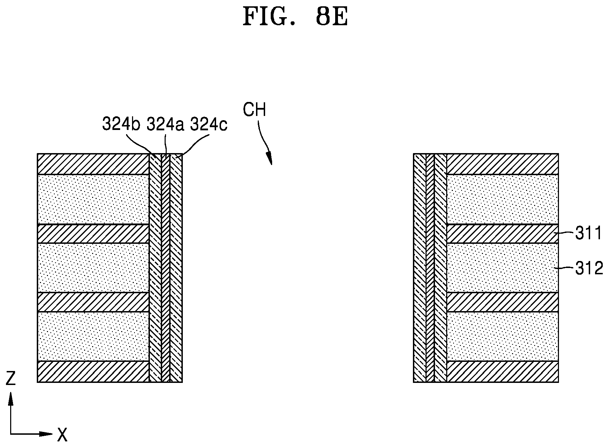

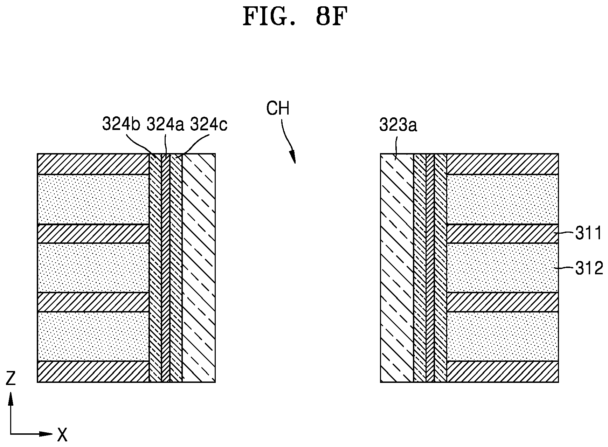

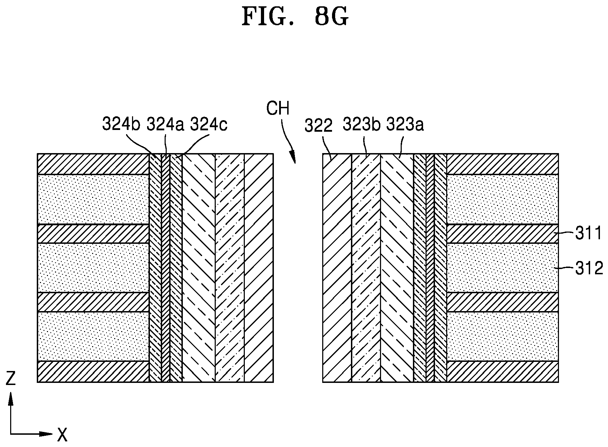

FIGS. 8A to 8G are views showing an example of a method of manufacturing the memory cell string CS illustrated in FIG. 7.

Referring to FIG. 8A, the insulating spacers 311 and the gate electrodes 312 may be alternately stacked in the first direction.

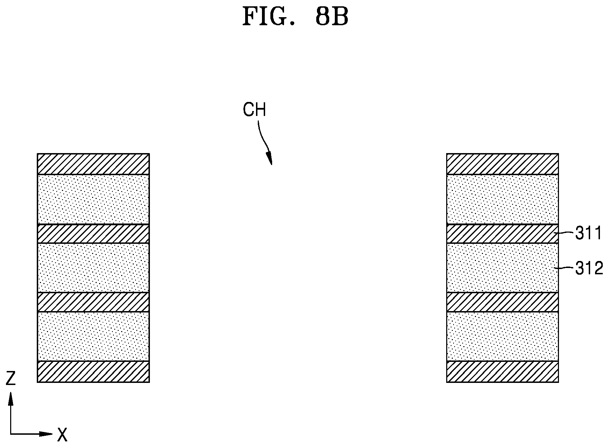

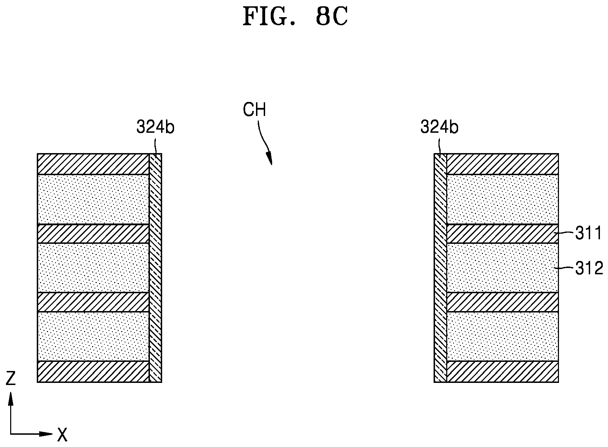

Referring to FIG. 8B, a channel hole CH may be formed by etching the center portions of the insulating spacers 311 and the gate electrodes 312. Then, referring to FIG. 8C, for example, by using an atomic layer deposition (ALD) method, the first barrier layer 324b may be conformally deposited along the side walls of the insulating spacers 311 and the side walls of the gate electrodes 312 within the channel hole CH.

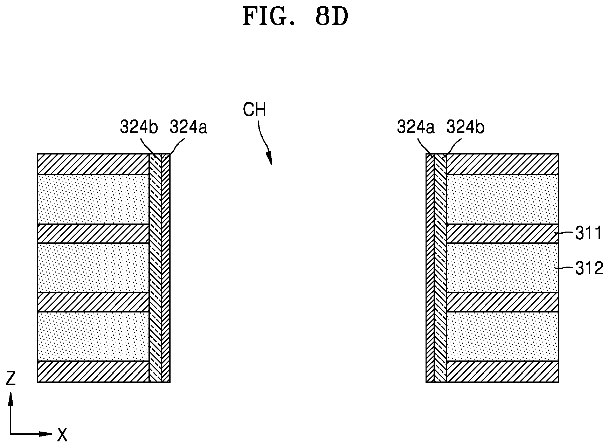

Then, as illustrated in FIGS. 8D to 8G, by using the ALD method, the charge trap layer 324a may be conformally deposited along the side wall of the first barrier layer 324b, the second barrier layer 324c may be conformally deposited along the side wall of the charge trap layer 324a, the ion reservoir layer 323a may be conformally deposited along the side wall of the second barrier layer 324c, the electrolyte layer 323b may be conformally deposited along the side wall of the ion reservoir layer 323a, and the channel layer 322 may be conformally deposited along the side wall of the electrolyte layer 323b. The remaining center portion of the channel hole CH may be left as an empty space, or the insulating support 321 may be deposited to fill the space in the remaining center portion of the channel hole CH.

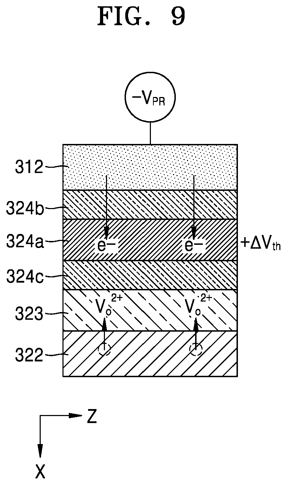

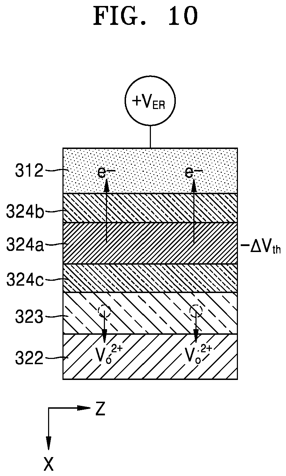

According to an example embodiment, in the memory cell string CS, a program operation and an erase operation may be independently performed for each memory cell MC of the memory cell string CS. FIG. 9 is a view showing an example of a program operation of the memory cell string CS according to an example embodiment. FIG. 10 is a view showing an example of an erase operation of the memory cell string CS according to an example embodiment. In FIGS. 9 and 10, for convenience, the insulating support 321 and symmetrical parts of the other layers illustrated in FIG. 5 are omitted.

Referring to FIG. 9, a negative (-) program voltage V_{PR} may be applied, through the word line WL, to the gate electrode 312 of a memory cell on which a program operation is to be performed, among the gate electrodes 312. Then, ions (e.g., oxygen vacancies) in a partial area of the channel layer 322 adjacent in the second direction to the gate electrode 312 to which the negative (-) program voltage V_{PR} is applied may be moved to a partial area of the electrochemical layer 323 adjacent in the second direction to the gate electrode 312 to which the negative (-) program voltage V_{PR} is applied. When the electrochemical layer 323 includes the ion reservoir layer 323a and the electrolyte layer 323b as illustrated in FIG. 7, the ions in the partial area of the channel layer 322 adjacent in the second direction to the gate electrode 312 to which the negative (-) program voltage V_{PR} is applied may be moved to a partial area of the ion reservoir layer 323a adjacent in the second direction to the gate electrode 312 to which the negative (-) program voltage V_{PR} is applied, by passing through the electrolyte layer 323b.

Accordingly, the concentration of donor ions, such as oxygen vacancies, in the channel layer 322 may be decreased. For example, when the partial area of the channel layer 322 has a first ion concentration that is relatively low, the partial area of the channel layer 322 has a first resistance that is relatively high or a first electrical conductivity that is relatively low. In this case, a transistor including the gate electrode 312 to which the negative (-) program voltage V_{PR} is applied, and a portion of the electrochemical layer 323 and a portion of the channel layer 322 which are adjacent in the second direction to the gate electrode 312, may have a first threshold voltage that is relatively high.

Furthermore, when the negative (-) program voltage V_{PR} is applied to the gate electrode 312, electrons may be moved from the gate electrode 312 to which the negative (-) program voltage V_{PR} is applied to a partial area of the charge trap layer 324a adjacent in the second direction to the gate electrode 312 to which the negative (-) program voltage V_{PR} is applied. Then, the electrons may be trapped in the partial area of the charge trap layer 324a adjacent in the second direction to the gate electrode 312 to which the negative (-) program voltage V_{PR} is applied. The electrons trapped in the charge trap layer 324a may serve to further increase the first threshold voltage by shifting the first threshold voltage in a positive direction (+ΔVₜₕ).

Referring to FIG. 10, a positive (+) erase voltage V_{ER} may be applied, through the word line WL, to the gate electrode 312 of a memory cell on which an erase operation is to be performed, among the gate electrodes 312. Then, ions in a partial area of the electrochemical layer 323 adjacent in the second direction to the gate electrode 312 to which the positive (+) erase voltage V_{ER} is applied may be moved to the partial area of the channel layer 322 adjacent in the second direction to the gate electrode 312 to which the positive (+) erase voltage V_{ER} is applied. When the electrochemical layer 323 includes the ion reservoir layer 323a and the electrolyte layer 323b as illustrated in FIG. 7, ions in a partial area of the ion reservoir layer 323a adjacent in the second direction to the gate electrode 312 to which the positive (+) erase voltage V_{ER} is applied may be moved to the partial area of the channel layer 322 adjacent in the second direction to the gate electrode 312 to which the positive (+) erase voltage V_{ER} is applied, by passing though the electrolyte layer 323b.

Accordingly, the concentration of donor ions, such as oxygen vacancies, in the channel layer 322 may be increased. For example, when the partial area of the channel layer 322 has a second ion concentration that is higher than the first ion concentration, the partial area of the channel layer 322 may have a second resistance lower than the first resistance or a second electrical conductivity higher than the first electrical conductivity. In this case, a transistor including the gate electrode 312 to which the positive (+) erase voltage V_{ER} is applied, and a portion of the electrochemical layer 323 and a portion of the channel layer 322 which are adjacent in the second direction to the gate electrode 312, may have a relatively low second threshold voltage. The second threshold voltage may be higher than the negative (-) program voltage V_{PR}, the first threshold voltage may be higher than the second threshold voltage, and the positive (+) erase voltage V_{ER} may be higher than the first threshold voltage.

Furthermore, when the positive (+) erase voltage V_{ER} is applied to the gate electrode 312, electrons may be moved from the partial area of the charge trap layer 324a adjacent in the second direction to the gate electrode 312 to which the positive (+) erase voltage V_{ER} is applied to the gate electrode 312 to which the positive (+) erase voltage V_{ER} is applied. Then, in the charge trap layer 324a adjacent in the second direction to the gate electrode 312 to which the positive (+) erase voltage V_{ER} is applied, the amount of electrons may be decreased and the amount of holes may be increased. Accordingly, the second threshold voltage may be further decreased by being further shifted in a negative direction (-ΔVₜₕ).

Among the gate electrodes 312, the gate electrode 312 of the other memory cells in which the program operation or the erase operation are not performed may be in a floating state in which no voltage is applied. Ions may not be moved between an area of the electrochemical layer 323 and areas of the channel layer 322 adjacent in the second direction to the gate electrode 312 in the floating state. Accordingly, the threshold voltage may not change in the other memory cells in which the program operation or the erase operation is not performed, among the gate electrodes 312.

Although FIGS. 9 and 10 illustrate only one memory cell as an example, the program operation or the erase operation may be simultaneously and independently performed on a plurality of memory cells in one memory cell string CS. For example, while the positive (+) erase voltage V_{ER} is being applied to the gate electrode 321 of one memory cell, the negative (-) program voltage V_{PR} may be applied to the gate electrode 321 of another memory cell adjacent thereto.

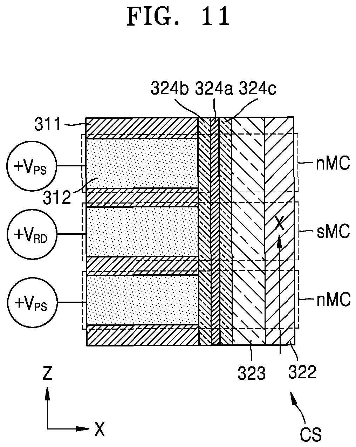

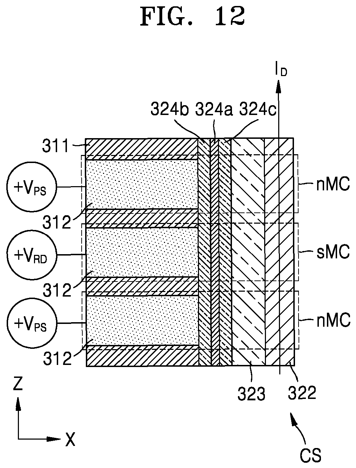

FIG. 11 is a view showing an example of a read operation on a selected memory cell of memory cell string CS according to an example embodiment after the program operation. FIG. 12 is a view showing an example of a read operation on a selected memory cell of the memory cell string CS according to an example embodiment after the erase operation. The read operation may be performed in a method of measuring a current I_{D} flowing along the channel layer 322 when, in the memory cell string CS, a positive (+) read voltage V_{RD} is applied to only the gate electrode 312 of a selected memory cell sMC from which data is to be read out and a positive (+) pass voltage V_{PS} is applied to the gate electrodes 312 of all the other unselected memory cells nMC. The read voltage V_{RD} may be higher than the program voltage V_{PR} and lower than the erase voltage V_{ER}. For example, the read voltage V_{RD} may be higher than the second threshold voltage when the ion concentration in the channel layer 322 is relatively high (e.g., when the channel layer 322 has the second ion concentration) and may be lower than the first threshold voltage when the ion concentration in the channel layer 322 is relatively low (e.g., when the channel layer 322 has the first ion concentration). The read voltage V_{RD} may also be lower than the pass voltage V_{PS}. The pass voltage V_{PS} may be higher than the first threshold voltage, the second threshold voltage, and the read voltage V_{RD}, and lower than the erase voltage V_{ER}. In other words, the read voltage V_{RD} may be a voltage to turn off the transistor of the memory cell MC when the channel layer 322 has the first ion concentration, and to turn on the transistor of the memory cell MC when the channel layer 322 has the second ion concentration. The pass voltage V_{PS} may be a voltage that does not cause move of ions between the channel layer 322 and the electrochemical layer 323 while turning on the transistor of the memory cell MC regardless of the ion concentration, resistance, or electrical conductivity of the channel layer 322.

Referring to FIG. 11, the transistors of the unselected memory cell nMC to which the pass voltage V_{PS} is applied are in a turn-on state. When the channel layer 322 of the selected memory cell sMC has the first ion concentration, the transistor of the selected memory cell sMC to which the read voltage V_{RD} is applied is in a turn-off state. In other words, the channel layer 322 of the selected memory cell sMC has a relatively high first resistance. Accordingly, current hardly flows in the channel layer 322 of the selected memory cell sMC, and thus, the current I_{D} hardly flows between the source and the drain through the channel layer 322. In other words, a relatively low first current flows between the source and the drain through the channel layer 322.

Reversely, referring to FIG. 12, when the channel layer 322 of the selected memory cell sMC has the second ion concentration, the transistor of the selected memory cell sMC to which the read voltage V_{RD} is applied is in a turn-on state. Accordingly, as all transistors in the memory cell string CS are in a turn-on state, the current I_{D} may flow along the channel layer 322 between the source and the drain through the channel layer 322. In other words, a second current that is greater that the first current flows between the source and the drain through the channel layer 322. By this method, the data written to the selected memory cell sMC may be read through the intensity of the current I_{D} between the source and the drain of the memory cell string CS.

According to an example embodiment, the absolute value of a driving voltage, such as the program voltage V_{PR} or the erase voltage V_{ER} described above, may be, for example, relatively low compared with the driving voltage of a memory device according to a charge trap flash (CTF) method. For example, the absolute value of the driving voltage of the memory cell string CS according to an example embodiment may be about 70% or less, about 60% or less, or about 50% or less of the absolute value of the driving voltage of the memory cell string according to the CTF method. Accordingly, during the program operation or erase operation on any one memory cell, as interference with adjacent memory cells is decreased due to a relatively low driving voltage, it is possible to increase a degree of integration of the memory cell string CS according to an example embodiment by reducing a distance between adjacent memory cells. For example, in the memory cell string CS according to an example embodiment, the distance between adjacent memory cells may be about 70% or less, about 60% or less, or about 50% or less of the distance between adjacent memory cells of the memory cell string CS according to the CTF method.

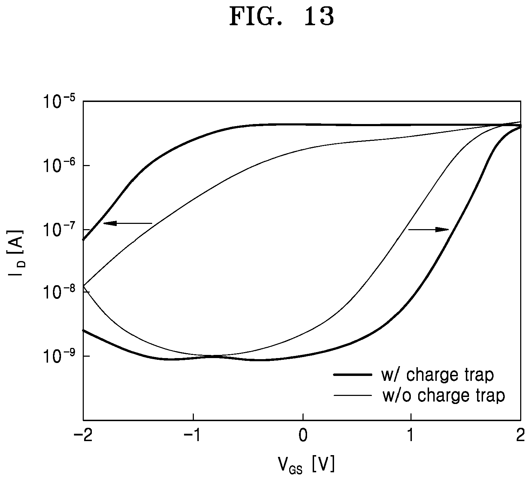

Furthermore, according to an example embodiment, as the memory cell string CS further includes the charge trap layer 324a, a memory window that is a difference between the first threshold voltage and the second threshold voltage may be further increased. FIG. 13 is a graph showing the principle of a memory window increase by a charge trap layer. In FIG. 13, a thin line denotes an example of voltage-current characteristics of a memory cell that does not include the charge trap layer 324a, and a thick line denotes voltage-current characteristics of a memory cell including the charge trap layer 324a. Referring to FIG. 13, the width of a hysteresis curve in a memory cell including the charge trap layer 324a may be greater than a memory cell that does not include the charge trap layer 324a. In other words, by further including the charge trap layer 324a, the second threshold voltage may be further shifted in the negative direction and the first threshold voltage may be shifted in the positive direction. Accordingly, the memory window of a memory cell including the charge trap layer 324a may be greater than the memory cell that does not include the charge trap layer 324a.

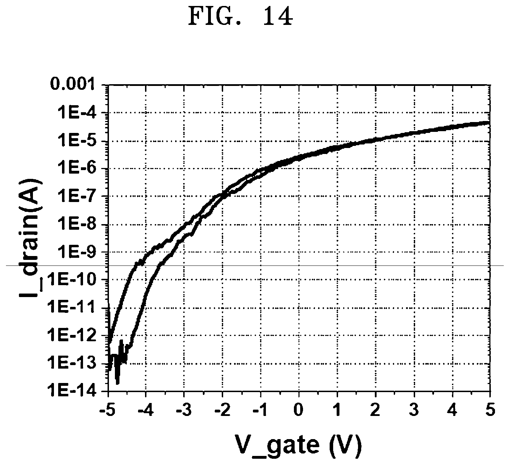

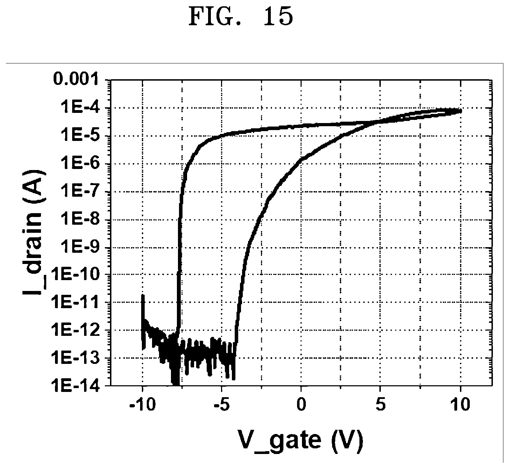

FIGS. 14 and 15 are graphs showing examples of voltage-current characteristics of one memory cell of a memory cell string according to a comparative example. The blocking layer 324 of the memory cell string according to the comparative example may include only the barrier layer, not the charge trap layer. In the comparative example, the barrier layer may include AlO and may have a thickness of about 10 nm in the second direction. A graph in FIG. 14 shows a result of sweeping the voltage applied to the gate electrodes 312 between -5 V and +5 V, and a graph in FIG. 15 shows a result of sweeping the voltage applied to the gate electrodes 312 between -10 V and +10 V. Referring to FIG. 14, when a voltage between -5 V and +5 V is applied to the gate electrodes 312, the first threshold voltage and the second threshold voltage may not be clearly distinguished. Accordingly, the memory cell string according to the comparative example may be difficult to perform a memory function with a driving voltage between -5 V and +5 V. Referring to FIG. 15, when a voltage between -10 V and +10 V is applied to the gate electrodes 312, the memory window that is a difference between the first threshold voltage and the second threshold voltage may be about 4 V. The threshold voltage is an application voltage when the memory cell is surely turned on, and in the graphs in FIGS. 14 and 15, an application voltage when a current between source-drain is about 1E-10A may be defined as the threshold voltage.

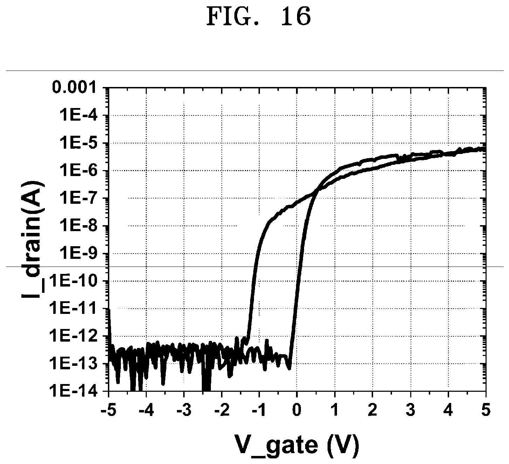

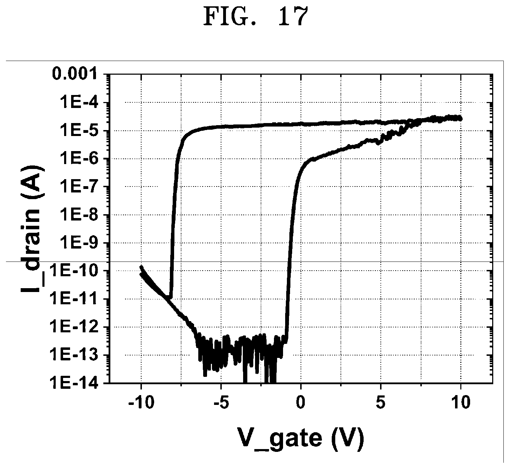

FIGS. 16 and 17 are graphs showing examples of voltage-current properties of one memory cell of the memory cell string CS according to an example embodiment. In FIGS. 16 and 17, in the memory cell string CS according to an example embodiment, the first barrier layer 324b may include aluminum oxide having a thickness of 2 nm in the second direction, the charge trap layer 324a may include silicon nitride having a thickness of 2 nm in the second direction, and the second barrier layer 324c may include aluminum oxide having a thickness of 6 nm in the second direction. A graph in FIG. 16 shows a result of sweeping the voltage applied to the gate electrodes 312 between -5 V and +5 V, and a graph in FIG. 17 shows a result of sweeping the voltage applied to the gate electrodes 312 between -10 V and +10 V. Referring to FIG. 16, it may be seen that the memory cell string CS according to an example embodiment may operate as a memory with a relatively low driving voltage of 5 V. This may be interpreted such that a hysteresis effect occurs first by the charge trap layer 324a because a voltage for inject charges into the charge trap layer 324a is lower than a voltage for ion exchange between the channel layer 322 and the electrochemical layer 323. Furthermore, referring to FIG. 17, when a voltage between -10 V and +10 V is applied to the gate electrodes 312, the memory window that is a difference between the first threshold voltage and the second threshold voltage may be about 7 V or more.

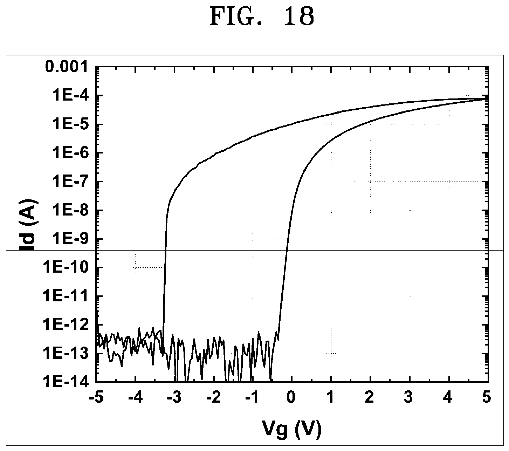

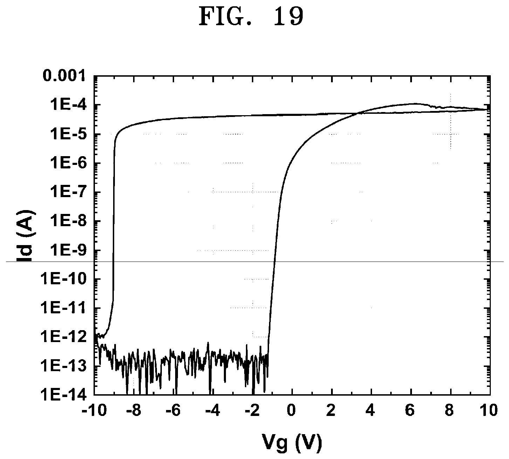

FIGS. 18 and 19 are graphs showing examples of voltage-current properties of one memory cell of a memory cell string CS according to another example embodiment. In FIGS. 18 and 19, in the memory cell string CS according to another example embodiment, the first barrier layer 324b may include silicon oxide having a thickness of 2 nm in the second direction, the charge trap layer 324a may include silicon nitride having a thickness of 2 nm in the second direction, and the second barrier layer 324c may include silicon oxide having a thickness of 6 nm in the second direction. A graph in FIG. 18 shows a result of sweeping the voltage applied to the gate electrodes 312 between -5 V and +5 V, and a graph in FIG. 19 shows a result of sweeping the voltage applied to the gate electrodes 312 between -10 V and +10 V. Referring to FIGS. 18 and 19, it may be seen that a memory window when the first and second barrier layers 324b and 324c include silicon oxide is greater than a memory window when the first and second barrier layers 324b and 324c include aluminum oxide. For example, when a voltage between -10 V and +10 V is applied to the gate electrodes 312, in an example embodiment in which the first and second barrier layers 324b and 324c include silicon oxide, a memory window may be about 8 V or more. This may be interpreted such that, as permittivity of silicon oxide is lower than that of aluminum oxide, a threshold voltage shift effect is increased. Accordingly, it is advantageous to use an oxide material having a relatively low permittivity for the first and second barrier layers 324b and 324c.

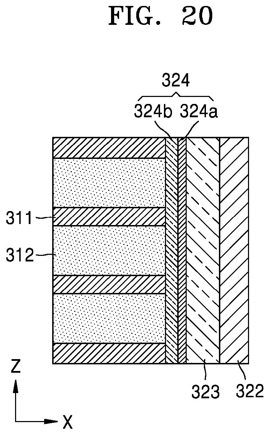

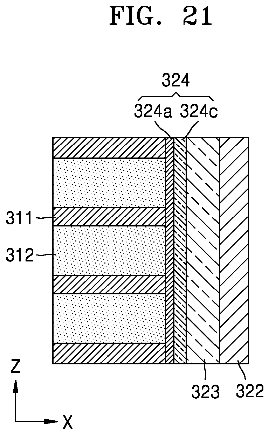

FIGS. 20 and 21 are vertical cross-sectional views schematically showing a structure of a memory cell string CS according to another example embodiment. In the above descriptions, the blocking layer 324 is described as including both of the first barrier layer 324b and the second barrier layer 324c, but one of the first barrier layer 324b or the second barrier layer 324c may be omitted. For example, when there is little risk of leakage of the charges trapped in the charge trap layer 324a to the gate electrodes 312, the first barrier layer 324b may be omitted, and when there is little risk of leakages of the charges trapped in the charge trap layer 324a to the electrochemical layer 323 and the ions in the electrochemical layer 323 to the charge trap layer 324a, the second barrier layer 324c may be omitted.

Referring to FIG. 20, the blocking layer 324 of the memory cell string CS may include only the first barrier layer 324b and the charge trap layer 324a. In this case, the charge trap layer 324a may be in direct contact with the electrochemical layer 323. Furthermore, referring to FIG. 21, the blocking layer 324 of the memory cell string CS may include only the charge trap layer 324a and the second barrier layer 324c. In this case, the charge trap layer 324a may be in direct contact with the gate electrodes 312 and the insulating spacers 311.

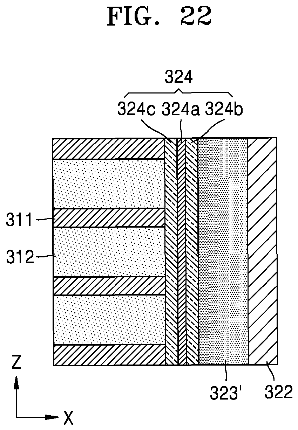

FIG. 22 is a vertical cross-sectional view schematically showing a structure of a memory cell string CS according to another example embodiment. Referring to FIG. 22, an electrochemical layer 323' may have a composition of gradually changing in the second direction. For example, the electrochemical layer 323' may have the highest oxygen composition at a first surface adjacent to the channel layer 322 and the lowest oxygen composition at a second surface adjacent to the blocking layer 324. To this end, a ratio of oxygen may gradually or continuously increase toward the channel layer 322 in the second direction within the electrochemical layer 323'. In this case, the concentration of ions, such as oxygen vacancies in the electrochemical layer 323' may gradually or continuously decrease toward the channel layer 322 in the second and gradually or continuously increase toward the blocking layer 324 in the second direction. Accordingly, in the electrochemical layer 323', a first region adjacent to the channel layer 322 may function as an electrolyte layer, and a second region adjacent to the blocking layer 324 may function as an ion reservoir layer.

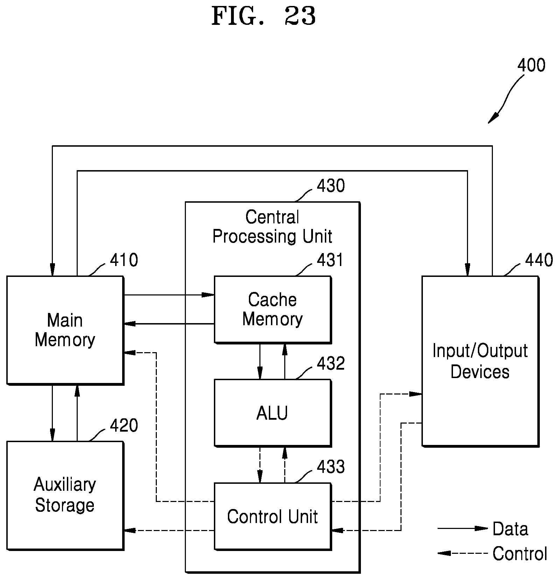

The memory device 200 described above may be used for storing data in various electronic devices. FIG. 23 is a schematic conceptual view of a device architecture applicable to an electronic device 400 including a memory device according to an example embodiment. Referring to FIG. 23, the electronic device 400 may include a main memory 410, an auxiliary storage 420, a central processing unit (CPU) 430, and an input/output device 440. The CPU 430 may include a cache memory 431, an arithmetic logic unit (ALU) 432, and a control unit 433. The cache memory 431 may include a static random access memory (SRAM). The main memory 410 may include a DRAM device, and the auxiliary storage 420 may include the memory device 200 according to the above example embodiment(s). Alternatively, the cache memory 431, the main memory 410, and the auxiliary storage 420 may all include the memory device 100 or 200 according to the above example embodiment(s). In some cases, the electronic device 400 may be implemented in the form of computing unit devices and memory unit devices being adjacent to each other in one chip, without distinction of the sub-units described above.

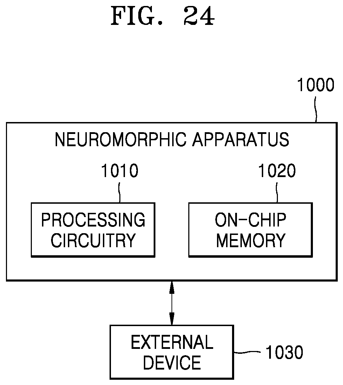

Furthermore, the memory device 200 may be used as a neuromorphic computing platform. For example, FIG. 24 is a schematic block diagram of a neuromorphic apparatus 1000 including the memory device 200 according to the above example embodiment(s). Referring to FIG. 24, the neuromorphic apparatus 1000 may include a processing circuitry 1010 and/or an on-chip memory 1020. The memory 1020 of the neuromorphic apparatus 1000 may include the memory device 200 according to the above example embodiment(s).

The processing circuitry 1010 may be configured to control functions to drive the neuromorphic apparatus 1000. For example, the processing circuitry 1010 may be configured to control the neuromorphic apparatus 1000 by executing a program stored in the on-chip memory 1020 of the neuromorphic apparatus 1000. The processing circuitry 1010 may include hardware such as a logic circuit, a combination of hardware and software such as a processor executing software, or a combination thereof. For example, the processor may include a CPU, a graphics processing unit (GPU), an application processor (AP) included in the neuromorphic apparatus 1000, an arithmetic logic unit (ALU), a digital processor, a microcomputer, a field programmable gate array (FPGA), a system-on-chip (SoC), a programmable logic unit, a microprocessor, an application-specific integrated circuit (ASIC), and the like. Furthermore, the processing circuitry 1010 may be configured to read and write various pieces of data from/in an external device 1030 and execute the neuromorphic apparatus 1000 by using the data. The external device 1030 may include a sensor array including an external memory and/or an image sensor (e.g., a CMOS image sensor circuit).

The neuromorphic apparatus 1000 of FIG. 24 may be applied to a machine learning system. Such machine learning systems may utilize various artificial neural network organizational and processing models, such as convolutional neural networks (CNN), de-convolutional neural networks, recurrent neural networks (RNN) optionally including long short-term memory (LSTM) units and/or gated recurrent units (GRU), stacked neural networks (SNN), state-space dynamic neural networks (SSDNN), deep belief networks (DBN), generative adversarial networks (GANs), and/or restricted Boltzmann machines (RBM).

Such machine learning systems may include other forms of machine learning models, such as, for example, linear and/or logistic regression, statistical clustering, Bayesian classification, decision trees, dimensionality reduction such as principal component analysis, and expert systems; and/or combinations thereof, including ensembles such as random forests. Such machine learning models may be used to provide various services, for example, an image classify service, a user authentication service based on bio-information or biometric data, an advanced driver assistance system (ADAS) service, a voice assistant service, an automatic speech recognition (ASR) service, or the like, and may be mounted and executed by other electronic devices.

The example embodiments described above are summarized as follows.
(1) In an example embodiment, a three-dimensional vertical non-volatile memory device includes a channel layer extending in a first direction, a plurality of gate electrodes and a plurality of insulating spacers alternately arranged in the first direction, each of the plurality of gate electrodes and each of the plurality of insulating spacers extending in a second direction crossing the first direction, an electrochemical layer extending in the first direction between the channel layer and the plurality of gate electrodes and between the channel layer and the plurality of insulating spacers, and a blocking layer extending in the first direction between the electrochemical layer and the plurality of gate electrodes and between the electrochemical layer and the plurality of insulating spacers, wherein the electrochemical layer and the channel layer are configured to move ions from the electrochemical layer to the channel layer or from the channel layer to the electrochemical layer according to a voltage applied to the plurality of gate electrodes, and the blocking layer includes a charge trap layer that extends in the first direction and is configured to trap charges according to the voltage applied to the plurality of gate electrodes.
(2) In an example, the charge trap layer may include, for example, at least one material of silicon nitride, aluminum nitride, hafnium nitride, silicon oxynitride, aluminum oxynitride, hafnium oxynitride, hafnium oxide, zirconium oxide, tantalum oxide, or titanium oxide.
(3) In another example, the charge trap layer may include a metal oxide material doped with Si or Al.
(4) The blocking layer may further include at least one of a first barrier layer extending in the first direction between the charge trap layer and the plurality of gate electrodes and between the charge trap layer and the plurality of insulating spacers, or a second barrier layer extending in the first direction between the electrochemical layer and the charge trap layer.
(5) The first barrier layer and the second barrier layer may each include at least one material of aluminum oxide, silicon oxide, hafnium oxide, or zirconium oxide.
(6) For example, the thickness in the second direction of the blocking layer may be about 5 nm to about 15 nm, and the thickness in the second direction of the charge trap layer may be about 1 nm to about 10 nm.
(7) In an example, the blocking layer may include both of the first barrier layer and the second barrier layer, and the thickness in the second direction of the first barrier layer may be less than the thickness in the second direction of the second barrier layer.
(8) The electrochemical layer may include, for example, oxide of at least one metal of Sc, Y, La, Ti, Zr, Hf, Rf, Ce, V, Nb, Ta, Cr, Mo, or W.
(9) In an example, when the electrochemical layer includes oxide of at least one metal of Sc, Y, or La, a ratio of oxygen atoms to metal atoms in the electrochemical layer may be about 1.35 or less; when the electrochemical layer includes an oxide of at least one metal of Ti, Zr, Hf, Rf, or Ce, a ratio of oxygen atoms to metal atoms in the electrochemical layer may be about 1.8 or less; when the electrochemical layer may include an oxide of at least one metal of V, Nb, or Ta, a ratio of oxygen atoms to metal atoms in the electrochemical layer may be about 2.25 or less; and when the electrochemical layer may include an oxide of at least one metal of Cr, Mo, or W, a ratio of oxygen atoms to metal atoms in the electrochemical layer may be about 2.7 or less.
(10) The electrochemical layer may include an ion reservoir layer extending in the first direction adjacent to the blocking layer and an electrolyte layer extending in the first direction adjacent to the channel layer.
(11) The ion reservoir layer and the electrolyte layer may each include oxide of at least one metal of Sc, Y, La, Ti, Zr, Hf, Rf, Ce, V, Nb, Ta, Cr, Mo, or W, and a ratio of oxygen to an entire material in the ion reservoir layer may be less than a ratio of oxygen to an entire material in the electrolyte layer.
(12) In an example, the thickness of the electrolyte layer in the second direction may be less than the thickness of the ion reservoir layer in the second direction.
(13) The electrochemical layer may have a composition in which a ratio of oxygen gradually or continuously increases toward the channel layer in the second direction within the electrochemical layer.
(14) The channel layer may include, for example, at least one oxide semiconductor material of IGZO, IZO, GZO, ZTO, or IWO.
(15) Furthermore, a method of driving a three-dimensional vertical non-volatile memory device may be provided, in which the three-dimensional vertical non-volatile memory device includes a channel layer extending in a first direction, a plurality of gate electrodes and a plurality of insulating spacers alternately arranged in the first direction, each of the plurality of gate electrodes and each of the plurality of insulating spacers extending in a second direction crossing the first direction, an electrochemical layer extending in the first direction between the channel layer and the plurality of gate electrodes and between the channel layer and the plurality of insulating spacers, and a blocking layer extending in the first direction between the electrochemical layer and the plurality of gate electrodes and between the electrochemical layer and the plurality of insulating spacers, the blocking layer including a charge trap layer that may be configured to trap charges according to a voltage applied to the plurality of gate electrodes.
   For example, the method of driving a three-dimensional vertical non-volatile memory device may include applying a negative (-) program voltage to one of the plurality of gate electrodes, moving and trapping electrons in a partial area of the charge trap layer adjacent in the second direction to one of the plurality of gate electrodes to which the program voltage may be applied, and moving ions in a partial area of the channel layer adjacent in the second direction to one of the plurality of gate electrodes to which the program voltage may be applied to a partial area of the electrochemical layer adjacent in the second direction to the one of the plurality of gate electrodes to which the program voltage may be applied, so that the partial area of the channel layer has a first resistance.
(16) The method of driving a three-dimensional vertical non-volatile memory device may further include applying a positive (+) erase voltage to one of the plurality of gate electrodes, moving electrons from a partial area of the charge trap layer adjacent in the second direction to one of the plurality of gate electrodes to which the erase voltage may be applied to the one of the plurality of gate electrodes to which the erase voltage may be applied, and moving ions in a partial area of the electrochemical layer adjacent in the second direction to a gate electrode to which the erase voltage may be applied to a partial area of the channel layer adjacent in the second direction to the one of the plurality of gate electrodes to which the erase voltage may be applied, so that the partial area of the channel layer has a lower second resistance than the first resistance.
(17) Some of the plurality of gate electrodes to which the program voltage or the erase voltage is not applied may be in a floating state, and ions may not be moved between an area of the electrochemical layer and an area of the channel layer adjacent in the second direction to the some of the plurality of gate electrodes in the floating state.
(18) The method of driving a three-dimensional vertical non-volatile memory device may further include applying a positive (+) read voltage to only a gate electrode of a selected memory cell from which data may be to be read out among the plurality of gate electrodes and applying a positive (+) pass voltage to other gate electrodes, wherein the read voltage may be higher than the program voltage and lower than the erase voltage, and the pass voltage may be higher than the read voltage and lower than the erase voltage.
(19) When a partial area of the channel layer adjacent in the second direction to a gate electrode to which the read voltage is applied has a first resistance, a first current may flow through the channel layer, and when the partial area of the channel layer adjacent in the second direction to the gate electrode to which the read voltage is applied has a second resistance, a second current that is greater than the first current may flow through the channel layer.
(20) Furthermore, an electronic apparatus including a processing circuit, and a three-dimensional vertical non-volatile memory device may be provided. The three-dimensional vertical non-volatile memory device may include a channel layer extending in a first direction, a plurality of gate electrodes and a plurality of insulating spacers alternately arranged in the first direction, each of the plurality of gate electrodes and each of the plurality of insulating spacers extending in a second direction crossing the first direction, an electrochemical layer extending in the first direction between the channel layer and the plurality of gate electrodes and between the channel layer and the plurality of insulating spacers, and a blocking layer extending in the first direction between the electrochemical layer and the plurality of gate electrodes and between the electrochemical layer and the plurality of insulating spacers, wherein the electrochemical layer and the channel layer are configured to move ions from the electrochemical layer to the channel layer or from the channel layer to the electrochemical layer according to a voltage applied to the plurality of gate electrodes, and the blocking layer may include a charge trap layer that extends in the first direction and may be configured to trap charges according to the voltage applied to the plurality of gate electrodes.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that the three-dimensional vertical non-volatile memory device including memory cell strings described above described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A three-dimensional vertical non-volatile memory device comprising:
a channel layer extending in a first direction;
a plurality of gate electrodes and a plurality of insulating spacers alternately arranged in the first direction, each of the plurality of gate electrodes and each of the plurality of insulating spacers extending in a second direction crossing the first direction;
an electrochemical layer extending in the first direction between the channel layer and the plurality of gate electrodes and between the channel layer and the plurality of insulating spacers; and
a blocking layer extending in the first direction between the electrochemical layer and the plurality of gate electrodes and between the electrochemical layer and the plurality of insulating spacers,
wherein the electrochemical layer and the channel layer are configured to move ions from the electrochemical layer to the channel layer or from the channel layer to the electrochemical layer according to a voltage applied to each of the plurality of gate electrodes, and
the blocking layer includes a charge trap layer that extends in the first direction and is configured to trap charges according to the voltage applied to each of the plurality of gate electrodes.

2. The three-dimensional vertical non-volatile memory device of claim 1, wherein the charge trap layer includes at least one material of silicon nitride, aluminum nitride, hafnium nitride, silicon oxynitride, aluminum oxynitride, hafnium oxynitride, hafnium oxide, zirconium oxide, tantalum oxide, or titanium oxide.

3. The three-dimensional vertical non-volatile memory device of claim 1 or 2, wherein the charge trap layer includes a metal oxide material doped with Si or Al.

4. The three-dimensional vertical non-volatile memory device of any preceding claim, wherein the blocking layer further includes at least one of a first barrier layer extending in the first direction between the charge trap layer and the plurality of gate electrodes and between the charge trap layer and the plurality of insulating spacers, or a second barrier layer extending in the first direction between the electrochemical layer and the charge trap layer, and optionally wherein the first barrier layer and the second barrier layer each include at least one material of aluminum oxide, silicon oxide, hafnium oxide, or zirconium oxide.

5. The three-dimensional vertical non-volatile memory device of claim 4, wherein
a thickness in the second direction of the blocking layer is 5 nm to 15 nm, and
a thickness in the second direction of the charge trap layer is 1 nm to 10 nm.

6. The three-dimensional vertical non-volatile memory device of claim 4 or 5, wherein
the blocking layer includes both of the first barrier layer and the second barrier layer, and
a thickness in the second direction of the first barrier layer is less than a thickness in the second direction of the second barrier layer.

7. The three-dimensional vertical non-volatile memory device of any preceding claim, wherein the electrochemical layer includes an oxide of at least one metal of scandium (Sc), yttrium (Y), lanthanum (La), titanium (Ti), zirconium (Zr), hafnium (Hf), rutherfordium (Rf), cerium (Ce), vanadium (V), niobium (Nb), tantalum (Ta), chromium (Cr), molybdenum (Mo), or tungsten (W), an optionally wherein:
when the electrochemical layer includes an oxide of at least one metal of Sc, Y, or La, a ratio of oxygen atoms to metal atoms in the electrochemical layer is 1.35 or less,
when the electrochemical layer includes an oxide of at least one metal of Ti, Zr, Hf, Rf, or Ce, a ratio of oxygen atoms to metal atoms in the electrochemical layer is 1.8 or less;
when the electrochemical layer includes an oxide of at least one metal of V, Nb, or Ta, a ratio of oxygen atoms to metal atoms in the electrochemical layer is 2.25 or less; and
when the electrochemical layer includes an oxide of at least one metal of Cr, Mo, or W, a ratio of oxygen atoms to metal atoms in the electrochemical layer is 2.7 or less.

8. The three-dimensional vertical non-volatile memory device of any preceding claim, wherein the electrochemical layer includes an ion reservoir layer extending in the first direction adjacent to the blocking layer and an electrolyte layer extending in the first direction adjacent to the channel layer, and optionally wherein:
the ion reservoir layer and the electrolyte layer each include an oxide of at least one metal of scandium (Sc), yttrium (Y), lanthanum (La), titanium (Ti), zirconium (Zr), hafnium (Hf), rutherfordium (Rf), cerium (Ce), vanadium (V), niobium (Nb), tantalum (Ta), chromium (Cr), molybdenum (Mo), or tungsten (W); and
a ratio of oxygen to an entire material in the ion reservoir layer is less than a ratio of oxygen to an entire material in the electrolyte layer, and further optionally wherein a thickness of the electrolyte layer in the second direction is less than a thickness of the ion reservoir layer in the second direction.

9. The three-dimensional vertical non-volatile memory device of any preceding claim, wherein the electrochemical layer has a composition in which a ratio of oxygen gradually or continuously increases toward the channel layer in the second direction within the electrochemical layer.

10. The three-dimensional vertical non-volatile memory device of any preceding claim, wherein the channel layer includes at least one oxide semiconductor material of indium-gallium-zinc oxide (IGZO), indium-zinc oxide (IZO), gallium-zinc oxide (GZO), zinc-tin oxide (ZTO), or indium tungsten oxide (IWO).

11. A method of driving a three-dimensional vertical non-volatile memory device, the three-dimensional vertical non-volatile memory device including
a channel layer extending in a first direction,
a plurality of gate electrodes and a plurality of insulating spacers alternately arranged in the first direction, each of the plurality of gate electrodes and each of the plurality of insulating spacers extending in a second direction crossing the first direction,
an electrochemical layer extending in the first direction between the channel layer and the plurality of gate electrodes and between the channel layer and the plurality of insulating spacers, and
a blocking layer extending in the first direction between the electrochemical layer and the plurality of gate electrodes and between the electrochemical layer and the plurality of insulating spacers, the blocking layer including a charge trap layer that is configured to trap charges according to a voltage applied to each of the plurality of gate electrodes, the method comprising:
applying a negative (-) program voltage to a first gate electrode of the plurality of gate electrodes;
moving and trapping electrons in a partial area of the charge trap layer adjacent in the second direction to the first gate electrode; and
moving ions in a partial area of the channel layer adjacent in the second direction to the first gate electrode to a partial area of the electrochemical layer adjacent in the second direction to the first gate electrode so that the partial area of the channel layer has a first resistance.

12. The method of claim 11, further comprising:
applying a positive (+) erase voltage to a second gate electrode of the plurality of gate electrodes;
moving electrons from a partial area of the charge trap layer adjacent in the second direction to the second gate electrode to the second gate electrode; and
moving ions in a partial area of the electrochemical layer adjacent in the second direction to the second gate electrode to a partial area of the channel layer adjacent in the second direction to the second gate electrode so that the partial area of the channel layer has a lower second resistance than the first resistance.

13. The method of claim 12, further comprising:
maintaining a third gate electrode of the plurality of gate electrodes to which the program voltage or the erase voltage is not applied in a floating state so that ions do not move between an area of the electrochemical layer and an area of the channel layer adjacent in the second direction to the third gate electrode.

14. The method of claim 12 or 13, further comprising:
applying a positive (+) read voltage to only a gate electrode of a selected memory cell from which data is to be read out among the plurality of gate electrodes and applying a positive (+) pass voltage to other gate electrodes,
wherein the read voltage is higher than the program voltage and lower than the erase voltage, and the pass voltage is higher than the read voltage and lower than the erase voltage.

15. The method of claim 14, wherein
when a partial area of the channel layer adjacent in the second direction to a gate electrode to which the read voltage is applied has a first resistance, a first current flows through the channel layer, and
when the partial area of the channel layer adjacent in the second direction to the gate electrode to which the read voltage is applied has a second resistance, a second current greater than the first current flows through the channel layer.
